# EUROPÄISCHE PATENTANMELDUNG

(11) **EP 1 239 512 A2**
(43) Veröffentlichungstag der Anmeldung: **11.09.2002**
(21) Anmeldenummer: 02005774.1
(22) Anmeldetag: 27.03.1997
(51) Int. Cl.: H01L 21/00

(54) **Vorrichtung zum Behandeln von Substraten in einem Fluid-Behälter**

(30) Priorität: 24.04.1996 DE 19616402
(62) Teilanmeldung aus: 97915453.1
(71) Anmelder: STEAG MicroTech GmbH, 72124 Pliezhausen (DE)
(72) Erfinder: Weber, Martin, 72124 Pliezhausen (DE); Oshinowo, John, 72124 Pliezhausen (DE)
(74) Vertreter: Geyer, Ulrich F., Dr. Dipl.-Phys.

(57) **Zusammenfassung**

Die Erfindung betrift eine Vorrichtung zum Behandeln von Substraten (5) in einem Fluid-Behälter (1), der Düsen (7) und eine Substrat-Aufnahmevorrichtung (6), die einen Halterungsbereich für die Halterung der Substrate (5) aufweist, und mit Führungen (4) für die Substrate (5) in bzw. auf der Innenfläche wenigstens einer Seitenwand (3) des Fluid-Behälters (1) Bereiche ohne Führungen aufweisen, und wobei Bereiche der Innenflächen ohne Führungen EinlaßÖffnungen, Sprühdüsen, Diffusoren, Ultraviolett-Lichtquellen und/oder Megasonic-Abstrahlvorrichtungen aufweisen. Eine derartige Vorrichtung ermöglicht optimale Strömungsverhältnisse im Fluid-Behälter und läßt große Umwälz- bzw. Fließgeschwindigkeiten zu.

## Beschreibung

Die Erfindung betrifft eine Vorrichtung zum Behandeln von Substraten in einem Fluid-Behälter,

Vorrichtungen dieser Art sind beispielsweise aus der US-PS 5 275 184 oder der auf dieselbe Anmelderin zurückgehenden DE-A-44 13 077 bekannt, bei der ein Fluid über eine Einlaßöffnung bzw. einen Diffusor in das Fluid-Becken eingeleitet wird und über einen Überlauf am oberen Ende aus ihm ausströmt. Bei Verwendung einer einzigen Zuströmöffnung am Boden des Fluidbehälters ist die pro Zeiteinheit einströmende Menge sowie die Geschwindigkeit des einströmenden Fluids begrenzt. Insbesondere ist es damit nicht möglich, im Behälter gleichmäßige Strömungsverhältnisse zu erreichen, um die im Fluid-Becken zu behandelnden Substrate oder Wafer über die gesamte Substratbreite oder -fläche hinweg gleichmäßig mit dem Fluid zu beaufschlagen bzw. zu umspülen. Bei Verwendung eines Diffusors ist es zwar möglich, das einströmende Fluid im Fluid-Behälter besser über die Fluidfläche hinweg zu verteilen, die pro Zeiteinheit einströmende Fluid-Menge und insbesondere auch die Einströmgeschwindigkeit des Fluids ist bei der Verwendung von Diffusoren aber stark beschränkt.

Aus der DE-A-4 413 077 ist eine Vorrichtung bekannt, bei der die Substrate innerhalb des Beckens mit einer im Becken auf- und abbewegbaren Vorrichtung gehalten werden, die Schlitze zur Aufnahme und Halterung der Substrate aufweist. Darüber hinaus ist aus dieser Druckschrift ersichtlich, dass in einer Haube seitliche Führungsschlitze vorgesehen sind.

Der Erfindung liegt daher die Aufgabe zugrunde, eine Vorrichtung zur Behandelung von Substraten in einem Fluid-Behälter zu schaffen, die optimale Strömungsverhältnisse im Fluidbehälter ermöglicht und große Umwälz- bzw. Fließgeschwindigkeiten zuläßt.

Die gestellte Aufgabe wird erfindungsgemäß durch die Merkmale des Anspruchs 1 gelöst.

Gemäß der Erfindung weist die Substrat-Aufnahmevorrichtung einen Halterungsbereich, etwa einen messerartigen Steg auf, wobei in bzw. auf der Innenfläche wenigstens einer Seitenwand des Fluid-Behälters Führungen für die Substrate vorgesehen sind. Dies hat den Vorteil, daß im Fluid-Becken für die Substrat-Aufnahmevorrichtung kein oder nur ein geringer Raumbedarf besteht, so daß das Behälter-Volumen und damit das Chemikalien-Volumen klein bleibt und die Prozeßkosten, die in erheblichem Maße vom Verbrauch der Chemikalien abhängen, kleingehalten werden können. Die Führungen werden beispielsweise durch Schlitze, vorzugsweise jedoch durch Stege, Stifte und/oder Noppen gebildet, die gegenüber Schlitzen den Vorteil haben, daß sie einfacher und schneller gesäubert und - falls erforderlich - getrocknet werden können. Beim Verdrängen eines Fluids durch ein anderes oder beim Umfüllen des Fluid-Behälters bleibt in den Schlitzen relativ viel Fluid haften und verunreinigt das nachfolgend eingeleitete Fluid.

Gemäß der Erfindung weisen die Innenflächen der Seitenwände des Fluid-Behälters Bereiche ohne Führungen auf. Ohne die sichere Führung und Halterung der Substrate im Fluid-Behälter zu beeinträchtigen, sind die Bereiche der Innenflächen ohne Führungen zu den Bereichen der Innenflächen mit Führungen vorzugsweise versetzt angeordnet. Wenn beispielsweise in einem Bereich der Innenfläche Führungen vorgesehen sind, sind Führungen auf der gegenüberliegenden Innenfläche nicht erforderlich, da Führungen auf einer Seite ausreichen. An den führungsfreien Bereichen der Innenflächen sind Einlaßöffnungen, Sprühdüsen, Diffusoren, Ultraviolett-Lichtquellen und/oder Megasonic-Abstrahlvorrichtungen vorgesehen.

Die Substrat-Aufnahmevorrichtung weist vorzugsweise drei Halterungsbereiche für die Halterung der Substrate auf. Durch die Halterung der Substrate an drei Stellen ist eine definierte Lage der Substrate sichergestellt, ohne daß Führungen im Fluid-Becken erforderlich sind. Die Substrat-Aufnahmevorrichtung ist vorzugsweise anheb- und absenkbar. Vorteilhaft ist es dabei, wenn wenigstens sein Halterungsbereiche ein messerartiger Steg ist, der quer zur Steglängsrichtung Schlitze zur Aufnahme der Substrat-Randbereiche aufweist. Vorzugsweise ist wenigstens ein Halterungsbereich relativ gegenüber wenigstens einem anderen Halterungsbereich in senkrechter Richtung bewegbar. Um Wiederholungen zu vermeiden, wird bezüglich dieses Merkmals auf die nicht vorveröffentlichte DE-.A-196 15 108 und DE-A- 195 46 990 derselben Anmelderin verwiesen, die zur Vermeidung von Wiederholungen insofern zum Gegenstand der vorliegenden Anmeldung gemacht werden.

Gemäß Ausführungsformen der Erfindung sind mehrere Düsen zum Einlassen der Fluids vorgesehen, um gewünschte Strömungsverhältnisse im Fluid-Behälter zu erreichen, so daß der gesamte zu behandelnde Substratbereich gleichmäßig von dem Fluid umspült und beaufschlagt wird. Durch die Verwendung von Düsen zur Einleitung des Fluids ist es auch möglich, das Fluid mit hohen Einströmgeschwindigkeiten und hohen Durchflußmengen pro Zeiteinheit in den Fluid-Behälter einzubringen und in ihm strömen zu lassen, so daß bei Aufrechterhaltung eines laminaren Stromes extrem hohe Fließgeschwindigkeiten erreicht werden. Dadurch wird nicht nur die Behandlung der Substrate verbessert, sondern auch der Behandlungsvorgang verkürzt, so daß die Produktivität der Vorrichtung erhöht wird.

Gemäß besonders vorteilhaften Ausgestaltungen der Erfindung weisen wenigstens einige Düsen unterschiedliche Abstrahlwinkel auf. Die Abstrahlformen der Düsen können vorzugsweise kegelförmig, aber auch fächerförmig sein, so daß die Einleitung des Fluids je nach den Gegebenheiten des Einzelfalles und der Lage der Düsen im Hinblick auf eine gleichmäßige, laminare Strömung im Fluid-Behälter und eine gleichmäßige Beaufschlagung der Substrate mit dem Fluid optimierbar ist.

Die Düsen sind vorzugsweise auf dem Boden des Fluid-Behälters und gemäß einer besonders vorteilhaften Ausführungsform matrixartig verteilt auf dem Boden des Behälters angeordnet. Auf diese Weise ergibt sich eine gleichmäßige Verteilung der Fluid-Zufuhr über die gesamte Fläche des Fluid-Behälters hinweg und insbesondere ist es auch möglich, in den Randbereichen optimale Strömungsverhältnisse zu schaffen.

Die Düsen sind vorteilhafterweise zu Düsengruppen zusammengefaßt, die vorzugsweise an unterschiedlichen Bodenbereichen des Behälters angeordnet sind. Vorteilhaft ist es, wenn eine Düsengruppe im mittleren Bereich und jeweils eine Düsengruppe in den beiden Außenbereichen vorgesehen ist, wobei die Dichte und Anzahl der Düsen in den einzelnen Bereichen unterschiedlich gewählt sein kann. Vorteilhaft ist es auch, wenn die einzelnen Düsen und/oder Düsengruppen voneinander getrennte Fluid-Versorgungseinrichtungen aufweisen, so daß die Düsen mit unterschiedlichem Fluid-Druck beaufschlagbar sind.

Gemäß einer sehr vorteilhaften Ausführungsform der Erfindung ist unter dem Boden des Fluid-Behälters ein Fluid-Zuführraum vorgesehen, mit dem die Düsen in Verbindung stehen. Dabei ist der Fluid-Zuführraum gemäß einer weiteren Ausführungsform der Erfindung in Teilräume für einzelne Düsen und/oder Düsengruppen unterteilt.

Der Fluid-Zuführraum unterhalb des Behälter-Bodens ist vorzugsweise in Form eines Zwischenraums zwischen einem doppelten Boden ausgebildet.

Gemäß einer weiteren sehr vorteilhaften Ausführungsform der Erfindung ist der Boden des Fluid-Behälters geneigt, vorzugsweise fällt der Boden jeweils zur Mitte, etwa zu einer Mittellinie oder zu einem Mittelpunkt des Fluid-Behälters hin ab. Auf diese Weise kann der Fluid-Behälter bei Ablassen des Fluids nach unten schnell und vollständig entleert werden.

Zum schnellen Ablassen des Fluids ist im Fluid-Behälter, und dort insbesondere in der Mitte bzw. in der Mittellinie, eine verschließbare Öffnung vorgesehen, die einen großen Durchmesser aufweist. Im Falle eines Stromausfalls oder einer sonstigen Unregelmäßigkeit, aber auch im Zusammenhang mit gängigen Verfahrensschritten ist es auf diese Weise möglich, die im Fluid-Behälter befindlichen Substrate schnell von dem Behandlungs-Medium, beispielsweise ätzenden Substanzen, zu befreien. Zur Aufnahme des schnell abgelassenen Fluids ist vorzugsweise unterhalb des Fluidbeckens ein Auffangbehälter vorgesehen.

Eine weitere Ausführungsform der Erfindung besteht darin, zusätzlich zu oder statt den Düsen auf dem Behälter-Boden Düsen an den Seitenwänden des Fluid-Behälters vorzusehen, um auf diese Weise auch seitlich oder im Bereich des Übergangs des Fluid-Bodens zu den Seitenwänden Fluid in den Fluid-Behälter einzuleiten, damit die Strömungsverhältnisse weiter verbessert oder dadurch das Umwälzvolumen erhöht werden bzw. wird.

Gemäß einer weiteren sehr vorteilhaften Ausführungsform der Erfindung sind Düsen und/oder Düsengruppen für unterschiedliche Fluids vorgesehen. Die einzelnen Düsen und/oder Düsengruppen für unterschiedliche Gruppen sind dabei auch hinsichtlich der Zuleitungen und Pumpen voneinander getrennt, so daß die unterschiedlichen Fluids, etwa unterschiedliche Chemikalien, durch Düsen- und/oder Düsengruppen eingeleitet werden, die den Chemikalien zugeordnet sind. Auf diese Weise ist ein Fluid-Wechsel schnell und ohne die Gefahr einer Vermischung möglich, da an die jeweiligen Düsen immer nur die diesen Düsen zugeordneten Fluids gelangen.

Gemäß einer weiteren sehr vorteilhaften Ausführungsform der Erfindung werden zusätzlich zu den über die Düsen eingeleiteten Fluids weitere Fluids, beispielsweise zusätzliche Chemikalien, Gase, Ozon, Wasser usw. in den Fluid-Behälter eingeleitet. Insbesondere zur zusätzlichen Einleitung von Chemikalien, Gasen, Ozon oder Wasser ist im Fluid-Behälter wenigstens ein Diffusor vorgesehen.

Sehr vorteilhaft ist auch eine Ausführungsform der Erfindung, bei der Sprühdüsen im oberen Bereich des Fluid-Behälters, etwa an den Seitenwänden angeordnet sind, die zur Reinigung des Fluid-Behälters und/oder dazu dienen, die Substrate zwischen unterschiedlichen im selben Fluid-Behälter ablaufenden Verfahren, etwa zwischen dem Ätzprozess, dem Reinigungsprozess und dem Trocknungsvorgang zu befeuchten bzw. naß zu halten. Vorzugsweise werden hierfür Aerosole, Wasser, sonstige Chemikaliendämpfe eingesprüht, oder auch Fluids die auch von unten in die Fluid-Behälter eingeleitet werden.

Eine weitere vorteilhafte Ausführungsform der Erfindung besteht darin, eine über das Fluid-Becken bringbare Haube zu verwenden, die vorzugsweise wenigstens eine Fluid-Einlaßöffnung, insbesondere zum Einlassen eines Fluids für den Trocknungsvorgang nach dem MARANGONI-Prinzip, aufweist. Um Wiederholungen zu dieser Ausführungsform zu vermeiden, wird insbesondere auf die DE-A-44 13 077 sowie die nicht vorveröffentlichten, auf dieselbe Anmelderin zurückgehenden DE-A-195 00 239, DE-A-196 15 108 und DE-A-196 15 970, angemeldet am 22. April 1996, verwiesen, die insofern zum Gegenstand der vorliegenden Anmeldung gemacht werden.

Vorteilhaft ist weiterhin die Verwendung einer Heiz- und/oder Kühleinrichtung zum Erwärmen und/oder Kühlen des Fluids im Fluid-Behälter, mit der die Fluid-Temperatur auf einen wählbaren, optimalen Wert einstellbar ist. Auch ist die Verwendung einer Ultraviolett-Lichtquelle vorteilhaft, die am Boden und/oder an den Seitenwänden des Fluid-Behälters angeordnet ist.

Eine weitere vorteilhafte Ausgestaltung der Erfindung besteht darin, einen Substrat-Niederhalter etwa in Form einer Halteleiste vorzusehen, die auf den oberen Randbereich der Substrate auflegbar ist. Um Wiederholungen hierzu zu vermeiden, wird auf die auf dieselbe Anmelderin zurückgehende DE-A-196 15 970, angemeldet am 22. April 1996, verwiesen, die insofern zum Inhalt der vorliegenden Anmeldung gemacht wird.

Vorteilhaft ist weiterhin eine Megasonic-Abstrahlvorrichtung, die vorzugsweise in Form eines Megasonic-Transducers im Fluid-Behälter integriert ist bzw. sind. Ein vorteilhafter Anbringungsort ist dafür die vom Boden und den Seitenwänden gebildeten Ecken des Fluid-Behälters, wobei die Abstrahlrichtung bezüglich der Horizontalen vorzugsweise 45° beträgt.

Da mit der erfindungsgemäßen Vorrichtung der Behälter sehr schnell gefüllt werden kann, und eine starke Düsenwirkung beim Einbringen des Fluids in den Behälter auftritt, ist insbesondere eine Vorrichtung zum Abdecken des Fluid-Behälters vorteilhaft, die verhindert, daß Fluid in Form von Spritzern in eine vorhandene Haube gelangt, die vorzugsweise für den Trocknungsvorgang eingesetzt wird.

Die erfindungsgemäße Vorrichtung ist vorzugsweise mit einer Fluid-Aufbereitungseinrichtung verbunden, in der Fluids oder Fluidmischungen aufgefangen und aufbereitet werden, so daß sie wiederverwendet werden können und vorzugsweise in den Fluid-Behälter rückgeführt werden.

Vorteilhaft ist weiterhin eine Trenn-Anlage, in der die in der Abluft enthaltenen alkalischen und Säuredämpfe getrennt werden.

Insbesondere für die Behandlungs- und Spülvorgänge ist es vorteilhaft, wenn die Substrate im Fluid-Behälter gedreht werden können. Dafür ist vorzugsweise eine Vorrichtung vorgesehen, die die Substrate im Fluid-Behälter dreht.

Es ist vorteilhaft, die Fluids bei der Verwendung von Fluid-Mischungen vor dem Einbringen in den Fluid-Behälter vorzumischen.

Die Erfindung wird nachfolgend anhand von bevorzugten Ausführungsbeispielen unter Bezugnahme auf die Figuren erläutert. Es zeigen:
- Fig. 1: eine Ausführungsform der erfindungsgemäßen Vorrichtung im Querschnitt,
- Fig. 2: die in der Figur 1 gezeigte Vorrichtung in Aufsicht bzw. mit Blickrichtung von oben in den Fluid-Behälter, und
- Fig. 3: einen Querschnitt entlang einer Querschnittsfläche, die gegenüber der Querschnittsfläche der in Figur 1 gezeigten Darstellung um 90° gedreht ist.

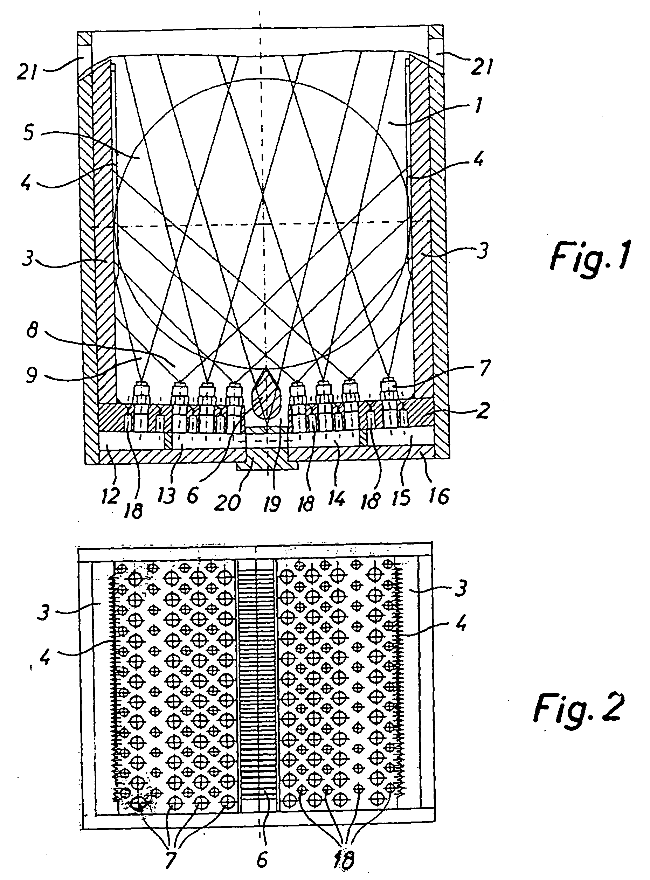

Wie aus den Figuren ersichtlich ist, weist der Fluid-Behälter 1 der erfindungsgemäßen Vorrichtung einen Boden 2 und Seitenwände 3 auf. Auf den in Figur 1 gegenüberliegenden Seitenwänden 3 sind Schlitze 4 vorgesehen, in denen Substrat-Scheiben 5 geführt sind, und die auf einer Substrat-Aufnahmevorrichtung 6 stehen, die mittels einer nicht dargestellten Antriebsvorrichtung in vertikaler Richtung beweglich ist und die Wafer 5 in den Fluid-Behälter 1 absenkt und aus ihm herausfährt. Die Substrat-Aufnahmevorrichtung 6 besteht bei dem dargestellten Ausführungsbeispiel aus einem messerartigen Steg mit Schlitzen oder Kerben, die entsprechend dem Abstand zwischen den Führungsschlitzen 4 in den einander gegenüberliegenden Seitenwänden 3 beabstandet sind.

Wie am besten aus Figur 1 ersichtlich ist, ist der Boden 2 auf beiden Seiten einer Mittellinie nach innen geneigt, so daß ein Fluid bei Entleerung des Behälters 1 in der Mitte nach unten ausströmt.

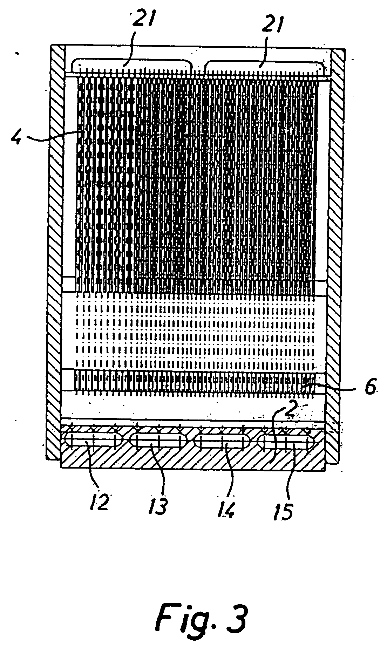

Der Boden 2 weist eine Vielzahl von Düsen 7 auf, die matrixförmig angeordnet sind, wie dies am besten aus Figur 3 zu ersehen ist. Die Düsen weisen unterschiedliche Düsenaustritts- bzw. Abstrahlwinkel 8, 9 auf, wie dies in Figur 1 eingezeichnet ist. Aufgrund der unterschiedlichen Abstrahlwinkel bzw. aufgrund der unterschiedlichen Abstrahlformen ergibt sich eine gute, gleichmäßige laminare Strömung über das gesamte Fluid-Behälterprofil hinweg und die Substrate 5 werden über die gesamte Breite hinweg gleichmäßig mit dem aus den Düsen 7 austretenden Fluid beaufschlagt.

Aus Figur 1 ist ersichtlich, daß unterhalb des Bodens 2 Hohlräume 12, 13, 14, 15 ausgebildet sind, die nach unten durch eine Abschlußplatte 16 abgeschlossen sind. Über die Hohlräume 12 bis 15 wird das Fluid den mit den jeweiligen Hohlräumen in Verbindung stehenden Düsen 7 zugeleitet.

Zwischen den Düsen 7 sind im Boden 2 Freispül-Öffnungen 18 vorgesehen, die entsprechend Figur 2 ebenfalls matrixförmig auf dem Boden 2 des Fluid-Behälters 1 verteilt sind. Die Freispül-Öffnungen 18 spülen die Bereiche des Bodens 2 zwischen den Düsen 7 frei und stehen ebenfalls für die Fluid-Zufuhr mit entsprechenden Fluid-Zuführräumen 12 bis 15 unterhalb des Bodens 2 in Verbindung.

Wie Figur 1 zeigt, ist in der Mitte des Bodens 2 eine Öffnung 19 für das schnelle Ablassen des im Fluid-Behälter 1 befindlichen Fluids vorgesehen, etwa dann, wenn Stromausfall eintritt und/oder die sich im Fluid-Behälter 1 befindenden Substrate 5 schnell aus der Fluid-Umgebung, beispielsweise einem Ätz-Medium, befreit werden müssen. Bei Öffnen eines Verschlusses 20 wird das Fluid innerhalb eines kleinen Zeitraums in einen nicht dargestellten, unter dem Fluid-Behälter 1 angeordneten Auffangbehälter entleert.

Die Substrat-Aufnahmevorrichtung 6 befindet sich im Bereich oberhalb des Verschlusses 20 teilweise innerhalb des Bodens 2 und ragt nur zu einem geringen Teil über die Düsenöffnungen nach oben hinaus. Dadurch ist innerhalb des Fluid-Behälters 1 nur wenig zusätzlicher Raum für die Substrat-Aufnahmevorrichtung erforderlich, so daß das Fluid-Volumen im Fluid-Behälter 1 klein gehalten werden kann.

Auf der Oberseite der Seitenwände 3 befinden sich Überlauf-Öffnungen 21, über die das von unten einströmende Fluid abfließt.

Die Erfindung wurde zuvor anhand eines bevorzugten Ausführungsbeispiels erläutert. Dem Fachmann sind jedoch zahlreiche Abwandlungen und Ausgestaltungen möglich, ohne daß dadurch der Erfindungsgedanke verlassen wird. Beispielsweise ist über dem Fluid-Behälter 1 eine Haube anbringbar, oder es sind an den Seitenwänden 3 des Fluid-Behälters 1, beispielsweise im oberen Bereich, Sprühdüsen zum Reinigen des Beckens oder zum Besprühen der Substrate 5 zwischen den einzelnen Verfahrensschritten und Behandlungsprozessen vorgesehen. Auch ist der Einsatz von Megasonic-Transducern, von Ultraviolett-Lichtquellen oder von Vorrichtungen zum Drehen der Wafer 5 im Fluid-Behälter 1 möglich, wie dies zuvor bereits beschrieben wurde.

## Patentansprüche

1. Vorrichtung zum Behandeln von Substraten (5) in einem Fluid-Behälter (1), der Düsen (7) und eine Substrat-Aufnahmevorrichtung (6), die einen Halterungsbereich für die Halterung der Substrate (5) aufweist, und mit Führungen (4) für die Substrate (5) in bzw. auf der Innenfläche wenigstens einer Seitenwand (3) des Fluid-Behälters (1) Bereiche ohne Führungen aufweisen, und wobei Bereiche der Innenflächen ohne Führungen Einlaß-Öffnungen, Sprühdüsen, Diffusoren, Ultraviolett-Lichtquellen und/oder Megasonic-Abstrahlvorrichtungen aufweisen.

2. Vorrichtung nach Anspruch 1, **dadurch gekennzeichnet, daß** die Führungen durch Schlitze, Stege, Stifte und/oder Noppen gebildet sind.

3. Vorrichtung nach Anspruch 1 oder 2, **dadurch gekennzeichnet, daß** Bereiche der Innenflächen ohne Führungen Bereichen der Innenflächen mit Führungen gegenüberliegend angeordnet sind.

4. Vorrichtung nach einem der vorhergehenden Ansprüche, **dadurch gekennzeichnet, daß** wenigstens einige Düsen (7) unterschiedliche Abstrahlwinkel (8, 9) aufweisen.

5. Vorrichtung nach einem der vorhergehenden Ansprüche, **dadurch gekennzeichnet, daß** wenigstens eine Düse (7) eine fächerförmige Abstrahlform aufweist.

6. Vorrichtung nach einem der vorhergehenden Ansprüche, **dadurch gekennzeichnet, daß** wenigstens eine Düse (7) eine kegelförmige Abstrahlform aufweist.

7. Vorrichtung nach einem der vorhergehenden Ansprüche, **dadurch gekennzeichnet, daß** die Düsen (7) auf dem Boden (2) des Fluid-Behälters (1) angeordnet sind.

8. Vorrichtung nach einem der vorhergehenden Ansprüche, **dadurch gekennzeichnet, daß** die Düsen (7) matrixförmig verteilt auf dem Behälter-Boden (2) angeordnet sind.

9. Vorrichtung nach einem der vorhergehenden Ansprüche, **dadurch gekennzeichnet, daß** die Düsen (7) zu Düsengruppen zusammengefaßt sind.

10. Vorrichtung nach einem der vorhergehenden Ansprüche, **dadurch gekennzeichnet, daß** die Düsengruppen an unterschiedlichen BodenBereichen des Fluid-Behälters (1) angeordnet sind.

11. Vorrichtung nach einem der vorhergehenden Ansprüche, **dadurch gekennzeichnet, daß** eine Düsengruppe im mittleren Bereich und jeweils eine Düsengruppe in den beiden Außenbereichen des Bodens (2) vorgesehen ist.

12. Vorrichtung nach einem der vorhergehenden Ansprüche, **dadurch gekennzeichnet, daß** der Boden des Fluid-Behälters (1) geneigt ist.

13. Vorrichtung nach Anspruch 12, **dadurch gekennzeichnet, daß** der Boden (2) jeweils zur Mitte des Fluid-Behälters (1) hin abfällt.

14. Vorrichtung nach einem der vorhergehenden Ansprüche, **gekennzeichnet durch** eine Öffnung (19) zum schnellen Ablassen des Fluids aus dem Fluid-Behälter (1).

15. Vorrichtung nach Anspruch 14, **gekennzeichnet durch** einen Auffangbehälter unterhalb des Fluid-Behälters (1) für das schnelle Ablassen des Fluids.

16. Vorrichtung nach einem der vorhergehenden Ansprüche, **dadurch gekennzeichnet, daß** Düsen (7) an den Seitenwänden (3) des Fluid-Behälters (1) vorgesehen sind.

17. Vorrichtung nach einem der vorhergehenden Ansprüche, **dadurch gekennzeichnet, daß** Düsen zum Einleiten zusätzlicher Fluids in den Fluid-Behälter (1) vorgesehen sind.

18. Vorrichtung nach Anspruch 17, **dadurch gekennzeichnet, daß** die zusätzlichen Fluids Chemikalien, Gase, Ozon und/oder Wasser sind.

19. Vorrichtung nach Anspruch 17 oder 18, **dadurch gekennzeichnet, daß** wenigstens ein Diffusor zum Einleiten zusätzlicher Fluids vorgesehen ist.

20. Vorrichtung nach einem der vorhergehenden Ansprüche, **gekennzeichnet durch** Sprühdüsen, die an den Seitenwänden vorzugsweise im oberen Bereich des Fluid-Behälters (1) angeordnet sind.

21. Vorrichtung nach Anspruch 20, **dadurch gekennzeichnet, daß** die Sprühdüsen zum Einsprühen von Chemikalien vorgesehen sind.

22. Vorrichtung nach einem der vorhergehenden Ansprüche, **gekennzeichnet durch** eine Vorrichtung zum Abdecken des Fluid-Behälters (1).

23. Vorrichtung nach einem der vorhergehenden Ansprüche, **gekennzeichnet durch** wenigstens eine Substrat-Halteleiste, die im oberen Randbereich auf den Substraten (5) aufliegt.

24. Vorrichtung nach einem der vorhergehenden Ansprüche, **gekennzeichnet durch** eine über das Fluid-Becken (1) bringbare Haube.

25. Vorrichtung nach Anspruch 24, **dadurch gekennzeichnet, daß** die Haube wenigstens eine Fluid-Einlaßöffnung aufweist.

26. Vorrichtung nach einem der vorhergehenden Ansprüche, **gekennzeichnet durch** eine Heiz- und/oder Kühleinrichtung zum Erwärmen und/oder Abkühlen des Fluids im Fluid-Behälter (1).

27. Vorrichtung nach einem der vorhergehenden Ansprüche, **gekennzeichnet durch** eine Fluid-Aufbereitungseinrichtung.

28. Vorrichtung nach einem der vorhergehenden Ansprüche, **gekennzeichnet durch** eine Trenn-Anlage zum Trennen von in der Abluft enthaltenen alkalischen und Säuredämpfen.

29. Vorrichtung nach einem der vorhergehenden Ansprüche, **gekennzeichnet durch** Ultraviolett-Lichtquellen, die am Boden (2) und/oder an den Seitenwänden (3) des Fluid-Behälters (1) angeordnet sind.

30. Vorrichtung nach einem der vorhergehenden Ansprüche, **gekennzeichnet durch** wenigstens eine Megasonic-Abstrahl-Vorrichtung.

31. Vorrichtung nach Anspruch 30, **dadurch gekennzeichnet, daß** die Megasonic-Abstrahl-Vorrichtung in den vom Boden (2) und den Seitenwänden (3) gebildeten Ecken des Fluid-Behälters (1) angeordnet ist.

32. Vorrichtung nach einem der vorhergehenden Ansprüche, **gekennzeichnet durch** eine die Substrate (5) im Fluid-Behälter (1) drehenden Vorrichtung.

33. Vorrichtung nach einem der vorhergehenden Ansprüche, **dadurch gekennzeichnet, daß** die Düsen (7) und/oder Düsengruppen für unterschiedliche Fluids vorgesehen sind.

34. Vorrichtung nach Anspruch 33, **dadurch gekennzeichnet, daß** Zuleitungen zu den für unterschiedliche Fluids vorgesehene Düsen (7) und/oder Düsengruppen jeweils getrennt voneinander vorgesehen sind.

35. Vorrichtung nach einem der Ansprüche 33 oder 34, **dadurch gekennzeichnet, daß** einzelne Düsen (7) und/oder Düsengruppen voneinander getrennte Fluid-Versorgungseinrichtungen aufweisen.

36. Vorrichtung nach einem der vorhergehenden Ansprüche, **dadurch gekennzeichnet, daß** ein Fluid-Zuführraum in Fluid-Teilräume (12, 13, 14, 15) für einzelne Düsen (7) und/oder Düsengruppen unterteilt ist.

37. Vorrichtung nach Anspruch 36, **dadurch gekennzeichnet, daß** der Fluid-Zuführraum (12, 13, 14, 15) durch einen Zwischenraum zwischen einem doppelten Boden (2, 16) gebildet ist.
